# EUROPÄISCHE PATENTSCHRIFT

(11) **EP 0 793 326 B1**
(45) Veröffentlichungstag und Bekanntmachung des Hinweises auf die Patenterteilung: **15.03.2000**
(21) Anmeldenummer: 96119653.2
(22) Anmeldetag: 07.12.1996
(51) Int. Cl.: H02J 7/00

(54) **Akku-Ladegerät für Elektrohandwerkzeuge**
Battery charger for electrical hand-tools
Chargeur de batterie pour des outils à main électriques

(30) Priorität: 27.02.1996 DE 19607226
(43) Veröffentlichungstag der Anmeldung: 03.09.1997
(73) Patentinhaber: Metabowerke GmbH & Co., D-72622 Nürtingen (DE)
(72) Erfinder: Eberle, Robert, 72622 Nürtingen (DE); Haller, Ulrich, 70597 Stuttgart (DE)
(74) Vertreter: Dreiss, Fuhlendorf, Steimle & Becker, Patentanwälte

(56) Entgegenhaltungen:
- DE-A- 4 442 049
- DE-C- 4 026 020
- GB-A- 2 217 520
- GB-A- 2 286 493
- BROWN BOVERI REVIEW, Bd. 70, Nr. 12, Dezember 1983, SWITZRLAND, Seiten 546-554, XP002028888 K.TAPAVICA: "TRNSISTORIZED POWER SUPPLY UNITS FOR RAILWAY COACHES"

## Beschreibung

Die Erfindung betrifft ein Ladegerät für einen aufladbaren Akkupack eines Elektrohandwerkzeugs, mit einem Belüftungsöffnungen aufweisenden Gehäuse und einer innerhalb des Gehäuses im wesentlichen parallel zu einem geschlossenen Gehäuseboden angeordneten und die elektrischen Bauteile tragenden Leiterplatte.

Derartige Ladegeräte sind bekannt, und es tritt immer wieder das Problem einer ausreichenden Kühlung der elektrischen Bauteile im Inneren des Gehäuses auf. Bei nicht ausreichender Kühlung kann es im Fehlerfall zu einer solchen Überhitzung kommen, daß die Lötverbindungen der Bauteile auf der Leiterplatte weich werden und sogar schmelzen, was zur Funktionsunfähigkeit des Gerätes führen kann. Mit dem Ladegerät, das unter dem Handelsnamen "RC-Universal" von der Firma ATLAS/COPCO erhätlich ist, ist bereits vorgeschlagen worden, im wesentlichen über die gesamte Höhe zweier Gehäuseseitenwände erstreckte Belüftungsschlitze vorzusehen. Es hat sich jedoch gezeigt, daß eine zufriedenstellende Kühlung durch diese Maßnahme nicht stets gewährleistet werden kann.

Ein aus der DE-A-44 42 049 bekanntes Ladegerät weist nur im oberen Bereich des Gehäuses Belüftungsöffnungen auf, die in Regenwasserablaufnuten vorgesehen sind. Unterhalb einer Leiterplatte ist eine Wärmeabstrahlungsplatte vorgesehen, die in thermischer Verbindung mit wärmeerzeugenden elektrischen Bauteilen steht.

Der vorliegenden Erfindung liegt die Aufgabe zugrunde, ein Ladegerät der eingangs genannten Art dahingehend zu verbessern, daß im Inneren des Gehäuses eine effektivere Kühlung der elektrischen Bauteile auf der Leiterplatte erreicht werden kann.

Diese Aufgabe wird bei einem Ladegerät der gattungsgemäßen Art erfindungsgemäß dadurch gelöst, dass die Belüftungsöffnungen voneinander beabstandet unterhalb bzw. oberhalb der Leiterplatte angeordnet sind und dass die unterhalb der Leiterplatte vorgesehenen Belüftungsöffnungen in wenigstens einer Gehäuseseitenwand ausgebildet sind und dass in der Leiterplatte und/oder zwischen der Leiterplatte und der Innenseite wenigstens einer Gehäuseseitenwand wenigstens eine Luftaufstiegsöffnung ausgebildet ist.

Auf diese Weise kann bei einem erfindungsgemäßen Ladegerät eine wirksamere Kühlung bereitgestellt werden, da der Luftdurchsatz im Gehäuseinneren einerseits erhöht und andererseits eine effektivere Anströmung der Leiterplatte und der elektrischen Bauteile erreicht werden kann. Die im Inneren des Gehäuses befindliche Luft wird erwärmt, steigt durch die Luftaufstiegsöffnungen nach oben und zieht sogartig weitere Luft durch die unteren, als Lufteintrittsöffnungen fungierenden Belüftungsöffnungen nach, während die erwärmte Luft durch die oberen, als Luftaustrittsöffnungen fungierenden Belüftungsöffnungen aus dem Gehäuse austritt.

Die unterhalb der Leiterplatte in das Gehäuse eintretende einströmende Luft stellt bereits an der Unterseite der Leiterplatte eine wesentliche Kühlkapazität zur Verfügung, die durch die metallischen und daher gut wärmeleitenden Leiterbahnen auch schon unterhalb der Leiterplatte zur effektiven Kühlung der Bauteile beiträgt.

Diese Ausführungsform bietet den weiteren Vorteil, daß sie der US-Sicherheitsvorschrift UL 1012 für Ladegeräte ohne Netzsicherheitstrennung entspricht, die vorschreibt, daß sämtliche netzspannungsführenden Bauteile vom Gehäuseboden her nicht berührbar sein dürfen und der Gehäuseboden geschlossen sein muß. Die Erfindung wirkt sich also bei derartigen Werkzeugen als besonders vorteilhaft aus.

Die Belüftungsöffnungen können ansich einen beliebigen Querschnitt aufweisen; sie sind bevorzugtermaßen schlitzförmig und verlaufen schräg, senkrecht oder parallel zum Gehäuseboden.

Bei dem erfindungsgemäßen Ladegerät ist zwischen der Leiterplatte und der Innenseite wenigstens einer Gehäuseseitenwand wenigstens eine Luftaufstiegsöffnung ausgebildet. Zusätzlich oder alternativ dahn kann gemäß der Erfindung in der Leiterplatte selbst wenigstens eine Luftaufstiegsöffnung vorgesehen werden. Die in den Raum unterhalb der Leiterplatte einströmende Luft kann dann durch die eine oder vorzugsweise durch mehrere Luftaufstiegsöffnungen an der Gehäuseseitenwand nach oben steigen und die auf der Oberseite der Leiterplatte vorgesehenen elektrischen Bauteile kühlen und schließlich durch die oberen Luftaustrittsöffnungen das Gehäuse verlassen. Die genannte Luftaufstiegsöffnung zwischen der Leiterplatte und der Gehäuseseitenwand ist vorzugsweise schlitzförmig bzw. langgestreckt.

Die Luftaufstiegsöffnungen können auch von einer randoffenen Ausnehmung in der Leiterplatte begrenzt sein.

Bei einem bevorzugten Ladegerät werden die unterhalb der Leiterplatte vorgesehenen Belüftungsöffnungen nach unten hin von dem Gehäuseboden begrenzt und nach oben hin von einer nach innen vorspringenden Stufe oder einem Absatz an der Innenseite der Gehäusewand. Hierbei wird durch den Gehäuseboden einerseits und die Stufe oder den Absatz andererseits ein parallel zum Gehäuseboden verlaufender Strömungspfad definiert. Hierdurch wird die einströmende Luft in die Mitte des Gehäuses bzw. zum Zentrum der Leiterplatte geleitet.

Die Stufe oder der Absatz können gleichzeitig als Auflage für die Leiterplatte dienen.

Nach einer weiteren Ausgestaltung der Erfindung sind an der Innenseite wenigstens einer Gehäuseseitenwand Rippen angeformt, die die Leiterplatte auf Abstand von der Gehäuseseitenwand halten und so die Luftaufstiegsöffnungen bilden.

Um die Kühlkapazität der Luftströmung weiter zu erhöhen, erweist es sich als vorteilhaft, wenn auf der Leiterplatte ein Kühlblech oder Kühlrippen vorgesehen sind. Diese werden dann vorzugsweise derart angeordnet, daß sie von der aufsteigenden Luft gekühlt werden, also insbesondere oberhalb einer Luftaufstiegsöffnung. Weitere Vorteile der Erfindung ergeben sich aus den beigefügten Ansprüchen sowie der zeichnerischen Darstellung und nachfolgenden Beschreibung zweier bevorzugter Ausführungsformen des erfindungsgemäßen Ladegeräts. In der Zeichnung zeigt:
- Figur 1: eine Seitenansicht der ersten Ausführungsform des erfindungsgemäßen Ladegeräts;
- Figur 2: einen Schnitt durch das untere Gehäuseteil des Ladegeräts nach Figur 1 entlang der Linie II-II;
- Figur 3: eine Seitenansicht der zweiten Ausführungsform des erfindungsgemäßen Ladegeräts; und
- Figur 4: einen Schnitt durch das untere Gehäuseteil nach Figur 3 entlang der Linie IV-IV.

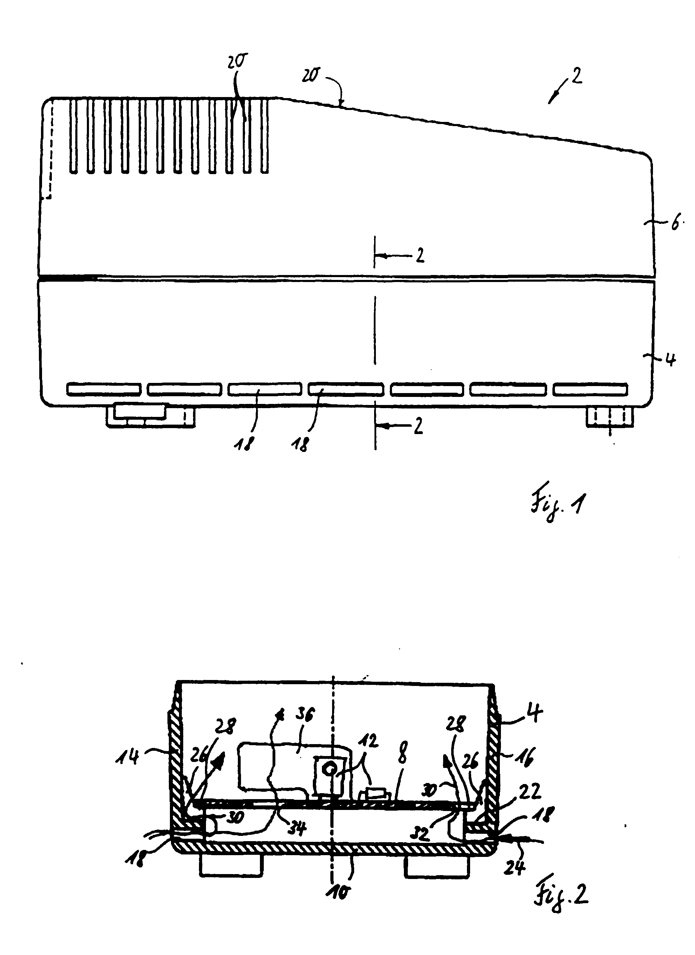

Ein in der Figur 1 dargestelltes Kondensatorladegerät umfaßt ein Gehäuse 2, das von einer unteren Gehäusehalbschale 4 und einer oberen Gehäusehalbschale 6 gebildet ist. Im Inneren des Gehäuses 2 ist eine Leiterplatte 8 im wesentlichen parallel verlaufend zu einem Gehäuseboden 10 des Gehäuses 2 angeordnet. Die Leiterplatte 8 trägt die mit dem Bezugszeichen 12 angedeuteten elektrischen Bauteile des Kondensatorladegeräts.

In den einander gegenüberliegenden Gehäuseseitenwänden 14 und 16 des Gehäuseunterteils 4 sind langgestreckte Belüftungsöffnungen 18 parallel zum Gehäuseboden 10 verlaufend angeordnet. Diese Belüftungsöffnungen münden im Inneren des Gehäuses 2 unterhalb der Ebene der Leiterplatte 8. Im Gehäuseoberteil 6 sind ebenfalls Belüftungsöffnungen 20 vorgesehen, die als Luftaustrittsöffnungen dienen. Die unteren, als Lufteintrittsöffnungen dienenden Belüftungsöffnungen 18 sind nach unten hin von dem Gehäuseboden 10 begrenzt und nach oben hin von einer nach innen vorspringenden Stufe 22 der Gehäuseseitenwände 14 und 16. Diese entlang der gesamten Erstreckung der Gehäuseseitenwände 14, 16 verlaufenden Stufe 22 bildet zusammen mit dem gegenüberliegenden Bereich des Gehäusebodens 10 einen parallel zum Gehäuseboden 10 verlaufenden Strömungspfad, der mit dem Bezugszeichen 24 angedeutet ist.

Oberhalb der Stufe 22 sind innerhalb des Gehäuses 2 senkrecht zum Gehäuseboden 10 verlaufende Rippen 26 angeformt, die einen parallel zum Gehäuseboden 10 verlaufenden Auflageabschnitt 28 aufweisen, auf welchem die Leiterplatte 8 abgestützt ist. Die Leiterplatte 8 ist somit in einem Abstand von der Stufe 22 angeordnet, so daß zwischen der Leiterplatte 8, der Stufe 22 und den jeweiligen Gehäuseseitenwänden 14, 16 mehrere Luftaufstiegsöffnungen oder -pfade, wie sie durch die Pfeile 30 dargestellt sind, gebildet werden. Durch diese Luftaufstiegsöffnungen oder -pfade 30 kann die durch die Belüftungsöffnungen 18 in den Raum unterhalb der Leiterplatte 8 einströmende Luft nach oberhalb der Leiterplatte 8 aufsteigen. Wie in der Figur 2 rechts dargestellt ist, sind in der Leiterplatte 8 randoffene Ausnehmungen 32 vorgesehen, welche die Luftaufstiegsöffnungen 30 noch vergrößern. Darüber hinaus ist im Inneren der Leiterplatte 8 eine weitere Luftaufstiegsöffnung 34 vorgesehen, oberhalb derer ein Kühlblech 36 so angeordnet ist, daß es von der durch die Öffnung 34 aufsteigenden Luft gekühlt wird.

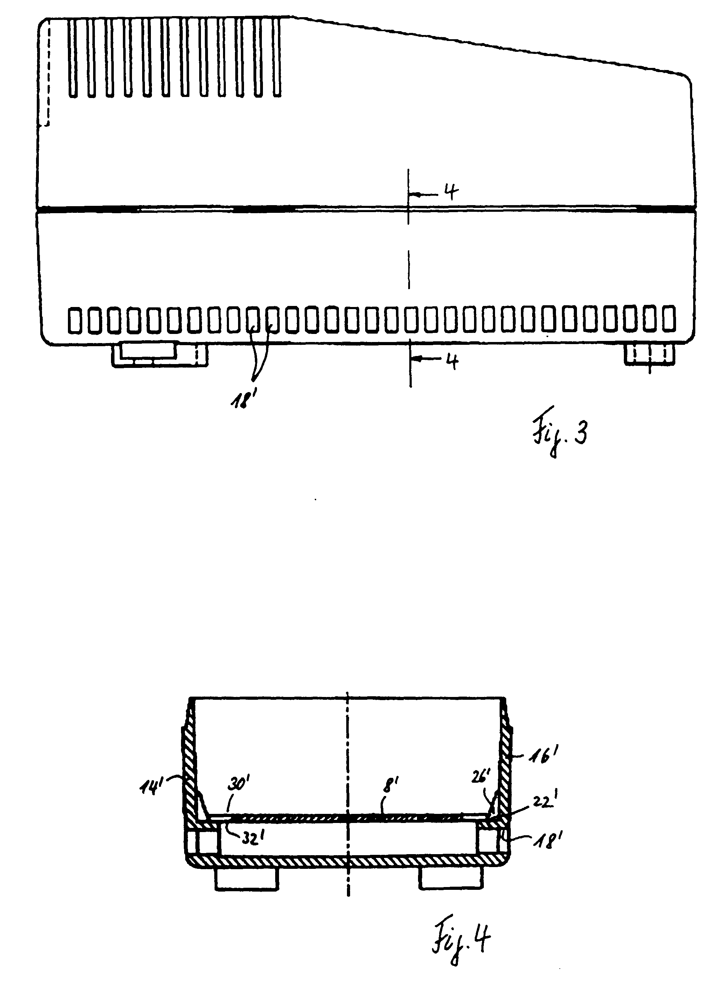

Die Ausführungsform nach Figur 3 unterscheidet sich von der vorbeschriebenen Ausführungsform dadurch, daß die unteren Belüftungsöffnungen 18' zwar auch langgestreckt, aber mit ihrer Längsseite quer zum Gehäuseboden 10 verlaufend angeordnet sind. Die auch bei dieser Ausführungsform vorgesehenen Rippen 26' weisen jedoch keinen Auflageabschnitt auf, sondern die Leiterplatte 8' liegt direkt auf der nach innen vorspringenden Stufe 22' der Gehäuseseitenwände 14', 16' auf. Zur Bildung von Luftaufstiegsöffnungen 30' weist die Leiterplatte 8' randoffene Ausnehmungen 32' auf.

## Patentansprüche

1. Ladegerät für einen aufladbaren Akkupack eines Elektrohandwerkzeugs, mit einem Belüftungsöffnungen (18, 20) aufweisenden Gehäuse (2) und einer innerhalb des Gehäuses (2) im wesentlichen parallel zu einem geschlossenen Gehäuseboden (10) angeordneten und die elektrischen Bauteile (12) tragenden Leiterplatte (8), **dadurch gekennzeichnet,** daß die Belüftungsöffnungen (18, 20) voneinander beabstandet unterhalb (18) bzw. oberhalb (20) der Leiterplatte (8) angeordnet sind und dass die unterhalb der Leiterplatte (8) vorgesehenen Belüftungsöffnungen (18) in wenigstens einer Gehäuseseitenwand (14, 16) ausgebildet sind und dass in der Leiterplatte (8) und/oder zwischen der Leiterplatte (8) und der Innenseite wenigstens einer Gehäuseseitenwand (14, 16) wenigstens eine Luftaufstiegsöffnung (34, 30) ausgebildet ist.

2. Ladegerät nach Anspruch 1, dadurch gekennzeichnet, daß die unterhalb der Leiterplatte (8) vorgesehenen Belüftungsöffnungen (18) schlitzförmig sind und senkrecht oder parallel zum Gehäuseboden (10) verlaufen.

3. Ladegerät nach Anspruch 1 oder 2, dadurch gekennzeichnet, daß die unterhalb der Leiterplatte (8) vorgesehenen Belüftungsöffnungen (18) nach unten hin von dem Gehäuseboden (10) begrenzt werden.

4. Ladegerät nach einem der vorstehenden Ansprüche, dadurch gekennzeichnet, daß die unterhalb der Leiterplatte (8) vorgesehenen Belüftungsöffnungen (18) nach oben hin von einer nach innen vorspringenden Stufe (22) oder einem Absatz an der Innenseite der Gehäusewand (14, 16) begrenzt sind.

5. Ladegerät nach Anspruch 4, dadurch gekennzeichnet, daß die Stufe (22) oder der Absatz an der Innenseite der Gehäusewand (14, 16) einen parallel zum Gehäuseboden (10) verlaufenden Strömungspfad (24) definieren.

6. Ladegerät nach Anspruch 4 oder 5, dadurch gekennzeichnet, daß die Stufe (22) oder der Absatz eine Auflage (28) für die Leiterplatte (8) bilden.

7. Ladegerät nach einem der vorstehenden Ansprüche, dadurch gekennzeichnet, daß die Luftaufstiegsöffnung (30) schlitzförmig ist.

8. Ladegerät nach einem der vorstehenden Ansprüche, dadurch gekennzeichnet, daß die Luftaufstiegsöffnung (30) von einer randoffenen Ausnehmung (32) in der Leiterplatte (8) begrenzt ist.

9. Ladegerät nach einem oder mehreren der vorstehenden Ansprüche, dadurch gekennzeichnet, daß an der Innenseite wenigstens einer Gehäuseseitenwand (14, 16) Rippen (26) angeformt sind, die die Leiterplatte (8) auf Abstand von der Gehäuseseitenwand (14, 16) halten und so die Luftaufstiegsöffnung (30) bilden.

10. Ladegerät nach Anspruch 9, dadurch gekennzeichnet, daß die Rippen (26) derart abgeschrägt sind, daß sie beim Einsetzen der Leiterplatte (8) eine Zentrierung derselben bewirken.

11. Ladegerät nach einem oder mehreren der vorstehenden Ansprüche, dadurch gekennzeichnet, daß auf der Leiterplatte (36) ein Kühlblech oder Kühlrippen vorgesehen sind.

12. Ladegerät nach Anspruch 11, dadurch gekennzeichnet, daß das Kühlblech (36) oder die Kühlrippen derart angeordnet sind, daß sie von der aufsteigenden Luft gekühlt werden.

## Claims

1. Charger for a rechargeable battery pack of an electric hand tool, with a housing (2) having ventilation holes (18, 20) and a printed circuit board (8) which is disposed inside the housing (2) substantially parallel to a closed housing base (10) and bears the electrical components (12), characterised in that the ventilation holes (18, 20) are disposed spaced from one another respectively below (18) or above (20) the printed circuit board (8) and that the ventilation holes (18) provided below the printed circuit board (8) are formed in at least one housing side wall (14, 16) and that at least one hole (34, 30) to permit air to rise is formed in the printed circuit board (8) and/or between the printed circuit board (8) and the inner face of at least one housing wall (14, 16).

2. Charger according to Claim 1, characterised in that the ventilation holes (18) provided below the printed circuit board (8) are slot-shaped and extend perpendicular to or parallel to the housing base (10).

3. Charger according to Claim 1 or 2, characterised in that the ventilation holes (18) provided below the printed circuit board (8) are delimited towards the . bottom by the housing base (10).

4. Charger according to one of the preceding claims, characterised in that the ventilation holes (18) provided below the printed circuit board (8) are delimited towards the top by an inwardly projecting step (22) or a shoulder on the inner face of the housing wall (14, 16).

5. Charger according to Claim 4, characterised in that the step (22) or shoulder on the inner face of the housing wall (14, 16) defines a flow path (24) extending parallel to the housing base (10).

6. Charger according to Claim 4 or 5, characterised in that the step (22) or the shoulder forms a support (28) for the printed circuit board (8).

7. Charger according to one of the preceding claims, characterised in that the hole (30) to permit air to rise is slot-shaped.

8. Charger according to one of the preceding claims, characterised in that the hole (30) to permit air to rise is delimited by a cut-out (32) which is open at the edge in the printed circuit board (8).

9. Charger according to one or more of the preceding claims, characterised in that formed on the inner face of at least one housing side wall (14, 16) are ribs (26) which keep the printed circuit board (8) spaced from the housing side wall (14, 16) and thus form the hole (30) to permit air to rise.

10. Charger according to Claim 9, characterised in that the ribs (26) are inclined in such a way that they centre the printed circuit board (8) as it is inserted.

11. Charger according to one or more of the preceding claims, characterised in that a cooling plate (36) [sic] or cooling ribs are provided on the printed circuit board (8).

12. Charger according to Claim 11, characterised in that the cooling plate (36) or the cooling ribs are disposed in such a way that they are cooled by the rising air.

## Revendications

1. Chargeur de batterie rechargeable d'un outil à main électrique, comportant un boîtier (2) pourvu d'ouvertures d'aération (18,20) et, à l'intérieur dudit boîtier (2), une plaque de circuits imprimés (8) agencée de manière sensiblement parallèle à une paroi inférieure fermée (10) dudit boîtier et portant les composants électriques (12), caractérisé en ce que les ouvertures d'aération (18,20) sont distantes les unes des autres et sont disposées respectivement au-dessous (18) et au-dessus (20) de la plaque de circuits imprimés (8), en ce que lesdites ouvertures d'aération (18) prévues sous ladite plaque (8) sont ménagées dans au moins une paroi latérale (14,16) du boîtier , et en ce qu'au moins une ouverture d'évacuation de l'air ascendant (34,30) est ménagée dans la plaque de circuits imprimés (8) et/ou entre ladite plaque de circuits imprimés (8) et la face interne d'au moins une paroi latérale (14,16) du boîtier.

2. Chargeur selon la revendication 1, caractérisé en ce que les ouvertures d'aération (18) prévues sous la plaque de circuits imprimés (8) affectent la forme de fentes et sont disposées perpendiculairement ou parallèlement à la paroi inférieure (10) du boîtier.

3. Chargeur de batterie selon la revendication 1 ou 2, caractérisé en ce que les ouvertures d'aération (18) prévues sous la plaque de circuits imprimés (8) sont délimitées, à leur extrémité inférieure, par la paroi inférieure (10) du boîtier.

4. Chargeur selon l'une des revendications précédentes, caractérisé en ce que les ouvertures d'aération (18) prévues sous ladite plaque de circuits imprimés (8) sont délimitées, à leur extrémité supérieure, par un talon (22) ou gradin dépassant intérieurement de la face interne (14,16) de la paroi du boîtier.

5. Chargeur selon la revendication 4, caractérisé en ce que le talon (22) ou gradin de la face interne (14,16) de la paroi de boîtier définit une voie d'écoulement (24) parallèle à la paroi inférieure (10) du boîtier.

6. Chargeur selon la revendication 4 ou 5, caractérisé en ce que le talon (22) ou gradin forme un support (28) pour la plaque de circuits imprimés (8).

7. Chargeur selon l'une des revendications précédentes, caractérisé en ce que l'ouverture d'évacuation de l'air ascendant (30) est en forme de fente.

8. Chargeur selon l'une des revendications précédentes, caractérisé en ce que l'ouverture d'évacuation de l'air ascendant (30) est délimitée par un évidement (32) formé dans la plaque de circuits imprimés (8) et présentant des bords ouverts.

9. Chargeur selon l'une ou plusieurs des revendications précédentes, caractérisé en ce que, sur la face interne d'au moins une paroi latérale du boîtier (14,16), sont formées des nervures (26) qui maintiennent la plaque de circuits imprimés (8) à distance de la paroi latérale (14,16) du boîtier, formant ainsi l'ouverture d'évacuation de l'air ascendant (30).

10. Chargeur selon la revendication 9, caractérisé en ce que les nervures (26) sont inclinées de telle façon qu'elles assurent le centrage de la plaque de circuits imprimés (8) lors de son montage.

11. Chargeur selon l'une ou plusieurs des revendications précédentes, caractérisé en ce qu'une tôle de refroidissement (36) ou des ailettes de refroidissement sont prévues sur la plaque de circuits imprimés.

12. Chargeur selon la revendication 11, caractérisé en ce que la tôle de refroidissement (36) ou les ailettes de refroidissement sont disposées de telle façon qu'elles sont refroidies par l'air ascendant.
